# EUROPÄISCHE PATENTSCHRIFT

(11) **EP 2 035 840 B1**
(45) Veröffentlichungstag und Bekanntmachung des Hinweises auf die Patenterteilung: **08.02.2017**
(21) Anmeldenummer: 07725948.9
(22) Anmeldetag: 11.06.2007
(51) Int. Cl.: G01R 27/04, G01R 31/28

(54) **VERFAHREN ZUM BETREIBEN EINER ANORDNUNG ZUM BESTIMMEN DER BETRIEBSKENNGRÖSSEN EINES HOCHFREQUENZ-LEISTUNGSVERSTÄRKERS**
METHOD FOR OPERATING AN ARRANGEMENT FOR DETERMINING THE OPERATIONAL CHARACTERISTICS OF A HIGH-FREQUENCY POWER AMPLIFIER
PROCÉDÉ DE FONCTIONNEMENT D'UN DISPOSITIF DE DÉTERMINATION DES PARAMÈTRES CARACTÉRISTIQUES DE FONCTIONNEMENT D'UN AMPLIFICATEUR DE PUISSANCE HAUTE FRÉQUENCE

(30) Priorität: 05.07.2006 DE 102006031053
(43) Veröffentlichungstag der Anmeldung: 18.03.2009
(73) Patentinhaber: Rohde & Schwarz GmbH & Co. KG, 81671 München (DE)
(72) Erfinder: HÖBEL, Daniel, 86825 Bad Wörishofen (DE); KÖHLER, Hendrik, 85399 Hallbergmoos (DE)
(74) Vertreter: Körfer, Thomas
(86) Internationale Anmeldenummer: PCT/EP2007/005133
(87) Internationale Veröffentlichungsnummer: WO 2008/003385

(56) Entgegenhaltungen:
- EP-A- 1 732 231
- EP-A1- 0 401 545
- EP-A1- 1 079 233
- DE-A1- 2 710 752
- JP-A- 2006 258 763
- US-A- 5 564 086
- US-A1- 2003 111 997

## Beschreibung

Die Erfindung betrifft ein Verfahren zum Betreiben einer Anordnung zum Bestimmen von Betriebs-Kenngrößen eines Hochfrequenz-Leistungsverstärkers.

Beim Betrieb von HF-Leistungsverstärkern, beispielsweise der Transistor-Leistungsendstufe eines frequenzvariablen Kurzwellensenders, ist es erforderlich, verschiedene Betriebskenngrößen am Ausgang des Leistungsverstärkers zu bestimmen. Dazu ist es aus der DE 27 10 752 A1 bzw. DE 39 18 159 A1 bekannt, auf der Verbindungsleitung zwischen Ausgang des Leistungsverstärkers und der komplexen Last, beispielsweise einer Antenne, mittels Richtkoppler die der vorlaufenden Welle proportionale Vorlaufspannung und die der rücklaufenden reflektierten Welle entsprechen Rücklaufspannung beispielsweise mittels Richtkoppler zu messen. Aus diesen in der HochfrequenzLage gemessenen analogen Spannungen wird dann meist mit einem analogen Rechenwerk die gewünschte Betriebskenngröße des Verstärkers berechnet. Ein Nachteil der bekannten Anordnungen ist, dass infolge der Verarbeitung der Messgrößen auf der HF-Ebene die Rechnungen relativ aufwendig und kompliziert sind, selbst wenn diese Berechnungen digital durchgeführt werden.

Die US 2003/0111997 A1 beschreibt eine Anordnung, bei der ein Leistungsverstärker ein Signal an eine Antennenlast gibt und eine Kopplerschaltung zum Abtasten einer Ausgangsleistung des Signals vorgesehen ist. An zwei Stellen, nämlich vor und hinter einer Anpassschaltung, werden jeweils ein Spannungssignal oder ein Spannungs- und ein Stromsignal einschließlich Größen- und Phaseninformationen abgetastet. Ein Prozessor berechnet aus den abgetasteten Signalen die Ausgangsleistung.

Die US 5,564,086 beschreibt eine Konfiguration, bei der eine Anpassungsschaltung zwischen Verstärker und Antenne vorliegt und ein Richtkoppler zwischen Anpassschaltung und Antenne angeordnet ist. Der Richtkoppler tastet eine Vorwärtskomponente und eine reflektierte Komponente eines Signals ab. Die abgetasteten Signalkomponenten werden an einen Pozessor gegeben, der daraus ein Rückkopplungssignal generiert, das an die Anpassschaltung gegeben wird.

Aus der EP 1 079 233 A1 geht eine Anordnung zum Bestimmen von Parametern für eine Abstimmeinheit hervor. Dazu hat die Verbindungsleitung zwischen dem Verstärker und der Antenne einen Abgriff zur Bestimmung der komplexen Spannung. Ein Stromwandler dient zur Bestimmung des komplexen Stromes. Die Koppelspule zur Bestimmung des komplexen Stromes ist mit einem Frequenztransponder zur weiteren Auswertung verbunden.

Die DE 27 10 752 A1 zeigt eine Anordnung zum Messen der vor- und rücklaufenden Welle auf einer Hochfrequenz-Leitung mit einem Richtkoppler.

Es ist Aufgabe der Erfindung, ein Betriebsverfahren für eine Anordnung dieser Art weiter zu entwickeln.

Diese Aufgabe wird durch ein Verfahren mit den Merkmalen des Anspruchs 1 gelöst. Vorteilhafte Weiterbildungen ergeben sich aus den Unteransprüchen.

Gemäß der Erfindung werden die jeweils getrennt ermittelten und digitalisierten Vorwärts- und Rückwärtsspannungen auf der Verbindungsleitung zwischen Leistungsverstärker und Last durch digitale Abwärtswandler in das Basisband herabgemischt, also auf die Trägerfrequenz 0Hz. Dadurch wird die Abtastrate herabgesetzt und die anschließende Berechnung der verschiedenen Betriebskenngrößen im Rechner wird wesentlich einfacher. Außerdem wird eine bessere Auflösung erreicht. Die getrennte Gewinnung der Vorwärts- bzw. Rückwärts-Spannung auf der Leitung erfolgt in bekannter Weise beispielsweise mittels Richtkoppler. Eine andere Möglichkeit besteht darin, hierfür eine Anordnung zu verwenden, die auf rechnerischem Wege die Ermittlung der Vorwärts- und Rückwärtsspannung bereits in digitaler Form ermöglicht und die dann nur noch aus der Hochfrequenzlage ins Basisband herabgesetzt werden müssen. Vorzugsweise wird zwischen digitalem Abwärtswandler und Rechner noch ein Selektionsfilter vorgesehen.

Mit einer Anordnung können somit im Rechner mit geringem Rechenaufwand aus Betrag und Phase der Vorlaufspannung und Betrag und Phase der Rücklaufspannung die verschiedenen gewünschten Betriebskenngrößen des Verstärkers wie komplexe Vorwärts- bzw. Rückwärts-Leistung, die komplexe Lastimpedanz der Antenne, der Reflexionsfaktor bzw. der Welligkeitsfaktor auf der im allgemeinen als Koaxialleitung ausgebildeten Verbindungsleitung zwischen Ausgang des Hochfrequenz-Leistungsverstärkers und der Antenne unter Anwendung entsprechend bekannter Algorithmen berechnet werden. Mit der Anordnung können nicht nur die beispielhaft erwähnten oben genannten Betriebskenngrößen eines HF-Leistungsverstärkers bestimmt werden, sondern mit den im Rechner zur Verfügung gestellten Digitalwerten können unter Benutzung entsprechend bekannter Algorithmen auch noch andere Berechnungen durchgeführt werden, die für den Betrieb des Leistungsverstärkers von Nutzen sind. So kann beispielsweise mittels eines bekannten Algorithmus auf der Leitung digital demoduliert werden, und zwar nach demjenigen Demodulations-Modus, der dem Modulations-Modus bei der Erzeugung des über den Leistungsverstärker verstärkten Hochfrequenzsignals entspricht, also beispielsweise gemäß Amplitudenmodulation, Frequenzmodulation, Phasenmodulation oder beliebig anderer höherwertiger Modulationsarten.

Das so digital demodulierte Nutzsignal am Ausgang des Leistungsverstärkers kann dann zur qualitativen Beurteilung des Ausgangssignals zum Eingang des Funksystems zurückgeführt und dort beispielsweise mittels eines Mithörlautsprechers hörbar gemacht werden. Auf diese Weise kann ein so genanntes Side-Tone-Signal erzeugt werden, mit dem der Sprechkomfort eines Kurzwellen-Telefonie-Funksystems überwacht und verbessert werden kann. Diese Möglichkeit der Rückmeldung der eigenen Sprache ist den bisher verwendeten unmittelbaren Rückführungen nach dem Mikrofonverstärker auf einen Mithörlautsprecher überlegen, da ja sämtliche Stufen des Funksystems einschließlich Endverstärker mit beurteilt werden. Diese Möglichkeit der Demodulation des Nutzsignals unmittelbar am Fußpunkt der Antenne kann genauso gut bei CW-Betrieb bzw. bei der Übertragung von Digitalsignalen in vorteilhafter Weise zur Überwachung angewendet werden.

Eine andere Möglichkeit besteht darin, aus den dem Rechner zugeführten Digitalwerten, die der komplexen Vorlaufspannung entsprechen, die durch Nichtlinearität entstehenden Verzerrungen der Endstufe zu bestimmen.

Damit kann das dem Leistungsverstärker zugeführte Nutzsignal vor der Verstärkung in bekannter Weise gegenläufig zur Verzerrung vorverzerrt werden, so dass damit die Verzerrungen im Leistungsverstärker kompensiert werden. Diese Bestimmung der Verzerrung in der Endstufe kann auch während des Betriebs ständig überwacht werden, so dass auch bei einer Veränderung der Last, beispielsweise dem Anschalten einer anderen Antenne oder bei einem Frequenzwechsel über eine entsprechende Änderung der Vorverzerrung das System selbstständig linearisiert wird.

Als Rechner eignet sich jeder übliche Signalprozessor oder für spezielle Aufgaben ein so genanntes FPGA (Field Programmable Gate Aray), mit dem beispielsweise nach dem so genannten Cordic-Algorithmus die oben beschriebenen digitalen Berechnungen mit geringstem Aufwand berechnet werden können.

Die Erfindung wird im folgenden anhand einer schematischen Zeichnung und beispielhaften Berechnungsformeln an Ausführungsbeispielen näher erläutert. In der Zeichnung zeigt:

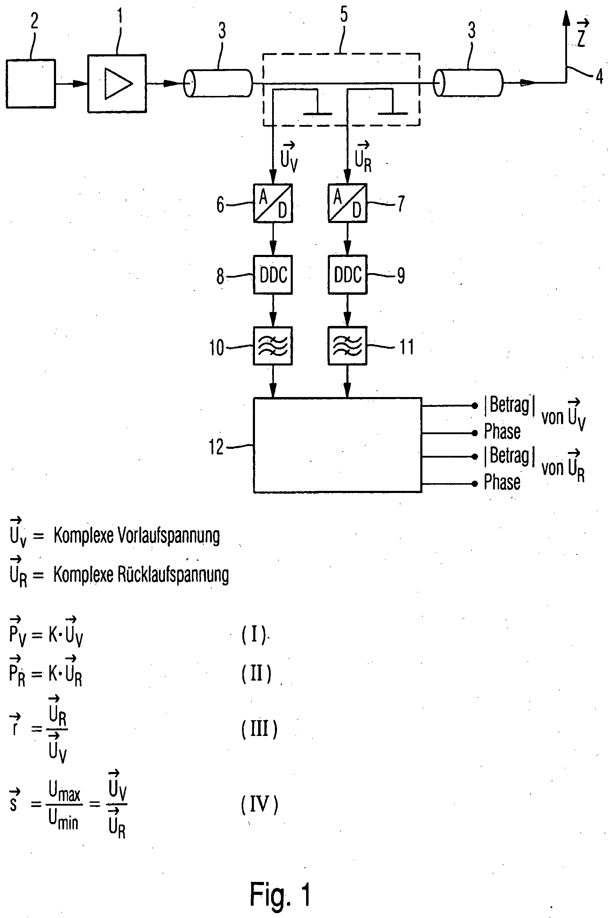

- Fig. 1: das Prinzipschaltbild einer Kurzwellen-Leistungsendstufe mit der erfindungsgemäßem Weiterbildung.

Die Fig. 1 zeigt das Prinzipschaltbild einer Kurzwellen-Leistungsendstufe mit einem HF-Leistungsverstärker 1, dem das zu verstärkende Nutzsignal aus einer Steuer- und Modulationseinrichtung 2 zugeführt wird. Der Ausgang des Leistungsverstärkers 1 speist über eine koaxial Verbindungsleitung 3 eine Antenne 4.

Mittels einer Koppeleinrichtung 5, beispielsweise einem Richtkoppler, wird die komplexe Vorlaufspannung *U̅_{V}* und die von der Antenne reflektierte komplexe Rücklaufspannung *U̅_{R}* gewonnen, die in A/D-Wandler 6, 7 digitalisiert werden. Anschließend werden diese getrennt gewonnenen digitalen Vorwärts- und Rückwärtsspannungen mittels digitaler Abwärtswandler 8, 9 (Digital Down Converter DDC) aus der HF-Ebene des HF-Signals ins Basisband (0Hz) herabgesetzt und schließlich nach Durchlaufen von Selektionsfiltern 10 und 11 in einem Rechner 12 weiterverarbeitet. Diese dem Rechner zugeführten und ins Basisband herabgemischten digitalen Vorwärts- und Rückwärtsspannungs-Werte enthalten noch sämtliche Phaseninformationen, so dass im Rechner 12 daraus die verschiedenartigsten komplexen Kenngrößen berechnet werden können, beispielsweise die komplexe Lastimpedanz oder die Streuparameter der Antenne.

Die komplexe Phaseninformation entsteht durch das gleichzeitige Abtasten und Verarbeiten der Vor- und Rückwärtsspannung in den beiden digitalen Abwärtswandlern 8 und 9. Die digitalen Abwärtswandler bestehen beispielsweise aus einem Mischer, der das Signal in das Basisband herabmischt, sowie einem zusätzlichen CIC-Filter (Cascaded Intergrated Comb-Filter). Durch Letzteres wird die Abtastrate von der HF-Lage auf die Basisbandlage reduziert. Mit den zusätzlichen Filtern 10 und 11 werden Spiegel- und Aliasprodukte unterdrückt. Auch hierdurch bleibt die Phaseninformation erhalten.

Die Berechnung der Betriebs-Kenngrößen des Verstärkers im Rechner 12 erfolgt nach bekannten Formeln der Leistungstheorie, wie sie beispielsweise in dem Lehrbuch von Meinke/Grundlach, Taschenbuch der Hochfrequenztechnik, beschrieben sind.

So kann aus der komplexen Vorlauf-Rücklaufspannung die komplexe Lastimpedanz *̅Z̅*̅ berechnet werden. Mit dieser damit bekannten komplexen Lastimpedanz kann dann durch adaptives Einschalten verschieden langer 50 Ohm Leitungsstücke zwischen Leistungsverstärker 1 und Antenne 4 die Leistungsaufnahme, Intermodulation und/oder der Oberwellenabstand verbessert werden, da durch die eingeschalteten Leitungsstücke die komplexe Anpassung so optimiert werden kann, dass der Leistungsverstärker in einem optimalen Anpassungsbereich betrieben wird. Auf diese Weise kann beispielsweise ein Tiefpasscharakter erzeugt und in einem kapazitiven Bereich gearbeitet werden, so dass der Oberwellenabstand verbessert wird. Auch die Verstärkung kann so optimiert werden, da der Leistungsverstärker besser an seine Streuparameter angepasst werden kann. Auf diese Weise kann also über die Berechnung der komplexen Lastimpedanz der Wirkungsgrad des Leistungsverstärkers optimiert werden.

Nach Beziehung (I) kann auch die komplexe Vorlaufleistung bzw. nach (II) die Rücklaufleistung berechnet werden, wobei k ein empirisch oder rechnerisch ermittelter Faktor ist, der von der Charakteristik der Kopplung und des Gesataufbaus abhängt. Nach Beziehung (III) kann beispielsweise auch der komplexe Reflexionsfaktor *̅r̅*̅ berechnet werden oder nach Beziehung (IV) der Welligkeitsfaktor s (VSWR).

Die Erfindung ist nicht auf das beschriebene Ausführungsbeispiel beschränkt. Auch eine digitale Demodulation des Nutzsignals ist, wie oben beschrieben, möglich, ebenso die Bestimmung der Verzerrungen des Verstärkers und die damit mögliche Linearisierung durch entsprechende Vorverzerrung des Eingangssignals.

## Patentansprüche

1. Verfahren zum Betreiben einer Anordnung zum Bestimmen von Betriebs-Kenngrößen eines Hochfrequenz-Leistungsverstärkers (1),
wobei die Betriebs-Kenngrößen komplexe Vor- und Rücklauf-Spannungen und/oder komplexe Vor- und Rücklauf-Leistungen und/oder eine komplexe Lastimpedanz und/oder ein Reflexionsfaktor und/oder ein Welligkeitsfaktor auf der Verbindungsleitung (3) zwischen dem Ausgang des Leistungsverstärkers (1) und einer komplexen Last sind,
wobei die Anordnung eine Koppeleinrichtung (5) aufweist, welche ausgebildet ist, um die komplexe analoge Vorlauf-Spannung und die komplexe analoge Rücklauf-Spannung auf der Verbindungsleitung (3) zu gewinnen,
wobei die Anordnung einen ersten Analog/Digital-Wandler (6) aufweist, um die komplexe analoge Vorlauf-Spannung (*U̅_{V}*) zu digitalisieren, und einen zweiten Analog/DigitalWandler (7) aufweist, um die komplexe analoge Rücklauf-Spannung (*U̅_{R}*) zu digitalisieren,
wobei die Anordnung einen ersten digitalen Abwärtswandler (8) aufweist, welche ausgebildet sind, um die digitale Vorlauf-Spannung in das Basisband um 0Hz herabzusetzen, und einen zweiten digitalen Abwärtswandler (9) aufweist, welcher ausgebildet ist, um die digitale Rücklauf-Spannung in das Basisband um 0Hz herabzusetzen,
wobei die Anordnung einen Rechner (12) aufweist, welcher aus den in das Basisband herabgesetzten digitalisierten analogen Vorlauf- und Rücklauf-Spannungen die gewünschten Betriebs-Kenngrößen berechnet, und
wobei aus der komplexen Vorlauf-Spannung und der komplexen Rücklauf-Spannung die komplexe Lastimpedanz der Last, welche eine Antenne ist, berechnet wird, und mit dieser damit bekannten komplexen Lastimpedanz durch adaptives Einschalten verschieden langer 50 Ohm Leitungsstücke zwischen dem Hochfrequenz-Leistungsverstärker (1) und der Antenne die Leistungsaufnahme, die Intermodulation und der Oberwellenabstand verbessert werden, indem durch die eingeschalteten Leistungsstücke die komplexe Anpassung so optimiert wird, dass der Hochfrequenz-Leistungsverstärker (1) in einem optimalen Anpassungsbereich betrieben wird.

2. Verfahren nach Anspruch 1,
wobei der Rechner (12) aus den in das Basisband herabgesetzten digitalisierten analogen Vorlauf- und Rücklauf-Spannungen die komplexe Vorlauf- und/oder Rücklauf-Leistung berechnet.

3. Verfahren nach einem der vorhergehenden Ansprüche, wobei der Rechner (12) aus den in das Basisband herabgesetzten digitalisierten analogen Vorlauf- und Rücklauf-Spannungen den komplexe Reflexionsfaktor berechnet.

4. Verfahren nach einem der vorhergehenden Ansprüche,
wobei der Rechner (12) den in das Basisband herabgesetzten digitalisierten analogen Vorlauf- und Rücklauf-Spannungen den Welligkeitsfaktor berechnet.

5. Verfahren nach einem der vorhergehenden Ansprüche,
wobei der Rechner (12) aus den in das Basisband herabgesetzten digitalisierten analogen Vorlauf- und Rücklauf-Spannungen nach demjenigen Modulations-Modus, der bei der Erzeugung eines über den Leistungsverstärker verstärkten HF-Signals verwendet wird, das HF-Signal digital demoduliert.

6. Verfahren nach Anspruch 5,
wobei der Rechner (12) aus den in das Basisband herabgesetzten digitalisierten analogen Vorlauf- und Rücklauf-Spannungen die Verzerrung des Leistungsverstärkers zu ermitteln und daraus dann die Kompensation dieser Verzerrung des zu verstärkenden HF-Signals berechnet.

## Claims

1. Method for operating an arrangement for determining the operational parameters of a high-frequency power amplifier (1),
wherein the operational parameters are complex forward and return voltage, and/or complex forward and return power and/or complex load impedance and/or reflection factor and/or standing wave ratio, on the connecting line (3) between the output of the power amplifier (1) and a complex load,
wherein the arrangement has a coupling device (5) that is designed to attain the complex analogue forward voltage and the complex analogue return voltage on the connecting line (3),
wherein the arrangement has a first analogue/digital converter (6), in order to digitize the complex analogue forward voltage (*U̅_{V}*), and has a second analogue/digital converter (7), in order to digitize the complex analogue return voltage (*U̅_{R}*),
wherein the arrangement has a first digital down-converter (8), which is designed to convert down the digital forward voltage into the baseband around 0 Hz, and has a second digital down-converter (9), which is designed to convert down the digital return voltage into the baseband around 0 Hz,
wherein the arrangement has a computer (12) that calculates the desired operational parameters from the digitized analogue forward and return voltages converted down into the baseband, and
wherein the complex load impedance of the load, which is an antenna, is calculated from the complex forward voltage and the complex return voltage, and, with this complex load impedance, which is therefore known, by adaptive insertion of 50 ohm line portions of different length between the high-frequency power amplifier (1) and the antenna, the power consumption, the inter-modulation and the harmonic spacing can be improved, as the complex matching can be optimized through the inserted line portions in such a manner that the high-frequency power amplifier (1) is operated within an optimum matching range.

2. Method according to Claim 1,
wherein the computer (12) calculates the complex forward and/or return power from the digitized analogue forward and return voltages converted down into the baseband.

3. Method according to either one of the preceding claims,
wherein the computer (12) calculates the complex reflection factor from the digitized analogue forward and return voltages converted down into the baseband.

4. Method according to any one of the preceding claims,
wherein the computer (12) calculates the voltage standing wave ratio from the digitized analogue forward and return voltages converted down into the baseband.

5. Method according to any one of the preceding claims,
wherein the computer (12) digitally demodulates the high-frequency signal from the digitized analogue forward and return voltages converted down into the baseband according to the modulation mode, which is used in the generation of a high-frequency signal amplified via the power amplifier.

6. Method according to Claim 5,
wherein the computer (12) determines, from the digitized analogue forward and return voltages converted down into the baseband, the distortion of the power amplifier, and then from this, calculates the compensation of this distortion of the high-frequency signal to be amplified.

## Revendications

1. Procédé pour faire fonctionner un agencement destiné à déterminer des grandeurs caractéristiques de fonctionnement d'un amplificateur de puissance haute-fréquence (1),
d'après lequel les grandeurs caractéristiques de fonctionnement sont des tensions aller et retour complexes et/ou des puissances aller et retour complexes et/ou une impédance de charge complexe et/ou un facteur de réflexion et/ou un facteur d'ondulation sur le conducteur de liaison (3) entre la sortie de l'amplificateur de puissance (1) et une charge complexe, d'après lequel l'agencement comprend un dispositif de couplage (5), qui est conçu pour obtenir la tension aller analogique complexe et la tension retour analogique complexe sur le conducteur de liaison (3),
d'après lequel l'agencement comprend un premier convertisseur analogique/numérique (6) pour numériser la tension aller analogique complexe (*U̅_{V}*), et un deuxième convertisseur analogique/numérique (7) pour numériser la tension retour analogique complexe (*U̅_{R}*),
d'après lequel l'agencement comprend un premier convertisseur-abaisseur numérique (8), qui est conçu pour abaisser la tension aller numérique dans la bande de base autour de 0Hz, et un deuxième convertisseur-abaisseur numérique (9), qui est conçu pour abaisser la tension retour numérique dans la bande de base autour de 0Hz,
d'après lequel l'agencement comprend un calculateur (12), qui calcule, à partir des tensions aller et retour numériques abaissées dans la bande de base, les grandeurs caractéristiques de fonctionnement souhaitées, et
d'après lequel à partir de la tension aller complexe et de la tension retour complexe, on calcule l'impédance de charge complexe de la charge, qui est une antenne, et à l'aide de cette impédance complexe ainsi connue, on améliore la puissance absorbée, l'intermodulation et la distance d'espacement des ondes supérieures, par insertion adaptative de tronçons de conducteur de 50 Ohm de longueur différente, entre l'amplificateur de puissance haute-fréquence (1) et l'antenne, grâce au fait que les tronçons de conducteur insérés produisent l'optimisation de l'adaptation complexe de façon telle, que l'amplificateur de puissance haute-fréquence (1) fonctionne dans une plage d'adaptation optimale.

2. Procédé selon la revendication 1,
d'après lequel le calculateur (12) calcule la puissance aller et/ou retour complexe à partir des tensions aller et retour analogiques, numérisées, abaissées dans la bande de base.

3. Procédé selon l'une des revendications précédentes,
d'après lequel le calculateur (12) calcule le facteur de réflexion complexe à partir des tensions aller et retour analogiques, numérisées, abaissées dans la bande de base.

4. Procédé selon l'une des revendications précédentes,
d'après lequel le calculateur (12) calcule le facteur d'ondulation à partir des tensions aller et retour analogiques, numérisées, abaissées dans la bande de base.

5. Procédé selon l'une des revendications précédentes,
d'après lequel le calculateur (12) assure, à partir des tensions aller et retour analogiques, numérisées, abaissées dans la bande de base, la démodulation numérique du signal HF d'après le mode de modulation, qui est utilisé lors de la production d'un signal HF amplifié par l'amplificateur de puissance.

6. Procédé selon la revendication 5,
d'après lequel le calculateur (12) est conçu pour déterminer, à partir des tensions aller et retour analogiques, numérisées, abaissées dans la bande de base, la distorsion de l'amplificateur de puissance, et calcule ensuite à partir de là, la compensation de cette distorsion du signal HF à amplifier.
